(19)

Europäisches
Patentamt
European
Patent Office
Office européen
des brevets

(11) **EP 3 396 862 A1**

(12) **EUROPEAN PATENT APPLICATION**

(43) Date of publication:
**31.10.2018 Bulletin 2018/44**

(51) Int Cl.:
***H03M 13/13*** *(2006.01)*   ***H03M 13/09*** *(2006.01)*

(21) Application number: **17305472.7**

(22) Date of filing: **27.04.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Nokia Technologies Oy**
**02610 Espoo (FI)**

(72) Inventors:
 • **JAYASINGHE, Keeth Saliya**
  **10300 Piliyandala (LK)**
 • **BAKER, Matthew**
  **CAMBRIDGE, Cambridgeshire CB24 6DD (GB)**
 • **ALLOUM, Amira**
  **92120 Montrouge (FR)**

(74) Representative: **Berthier, Karine**
**Alcatel-Lucent International**
**Patent Business**
**Site Nokia Paris Saclay**
**Route de Villejust**
**91620 Nozay (FR)**

(54) **USE OF CRC AND PARITY BITS FOR EARLY TERMINATION OF POLAR CODE DECODING FOR WIRELESS NETWORKS**

(57)    According to an example implementation, a technique or method of performing channel encoding may include: determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword; performing polar encoding on the codeword to obtain a polar encoded codeword; and transmitting the polar encoded codeword to a receiver within a wireless network.

**EP 3 396 862 A1**

## Description

TECHNICAL FIELD

This description relates to communications, channel encoding and decoding, and in particular, to use of CRC (cyclic redundancy check) and parity bits for early termination of polar decoding for wireless networks.

BACKGROUND

A communication system may be a facility that enables communication between two or more nodes or devices, such as fixed or mobile communication devices. Signals can be carried on wired or wireless carriers.

An example of a cellular communication system is an architecture that is being standardized by the 3rd Generation Partnership Project (3GPP). A recent development in this field is often referred to as the long-term evolution (LTE) of the Universal Mobile Telecommunications System (UMTS) radio-access technology. E-UTRA (evolved UMTS Terrestrial Radio Access) is the air interface of 3GPP's Long Term Evolution (LTE) upgrade path for mobile networks. In LTE, base stations or access points (APs), which are referred to as enhanced Node AP (eNBs), provide wireless access within a coverage area or cell. In LTE, mobile devices, user devices or mobile stations are referred to as user equipments (UEs).

Control channels may be used to carry control information. Control channels may include an uplink control channel and a downlink control channel. For example, a downlink control channel, such as a physical downlink control channel (PDCCH), may be used to carry downlink control information (DCI), such as a downlink scheduling assignment(s) (e.g., including resource information and transport format, control information for spatial multiplexing), an uplink scheduling grant(s) (e.g., including resource information and transport format), power control information or power control commands for one or more terminals or UEs, and/or other downlink control information.

In some cases, one or more cyclic redundancy check (CRC) bits may be appended to information bits, where the CRC bits may be used by a receiver for error detection and/or correction.

SUMMARY

According to an example implementation, a method of performing channel encoding is provided, and may include determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword, performing polar encoding on the codeword to obtain a polar encoded codeword, and transmitting the polar encoded codeword to a receiver within a wireless network.

According to an example implementation, an apparatus includes at least one processor and at least one memory including computer instructions, when executed by the at least one processor, cause the apparatus to determine a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword, perform polar encoding on the codeword to obtain a polar encoded codeword, and transmit the polar encoded codeword to a receiver within a wireless network.

According to an example implementation, a computer program product includes a non-transitory computer-readable storage medium and storing executable code that, when executed by at least one data processing apparatus, is configured to cause the at least one data processing apparatus to perform a method including: include determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword, performing polar encoding on the codeword to obtain a polar encoded codeword, and transmitting the polar encoded codeword to a receiver within a wireless network.

According to an example implementation, a method of performing channel decoding may include: receiving, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword, performing polar decoding of at least a portion of the polar encoded codeword to obtain one or more bits of the codeword, and performing early termination of the polar decoding based on a failure of at least one of the CRC bits or the at least one parity bit.

According to an example implementation, an apparatus includes at least one processor and at least one memory including computer instructions, when executed by the at least one processor, cause the apparatus to receive, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword, perform polar decoding of at least a portion of the polar encoded codeword to obtain one or more bits of the codeword, and perform early termination of the polar decoding based on a failure of at least one of the CRC bits or the at least one parity bit.

According to an example implementation, a computer program product includes a non-transitory computer-readable storage medium and storing executable code that, when executed by at least one data processing apparatus, is configured to cause the at least one data processing apparatus to perform a method including: receiving, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword, performing polar decoding of at least a portion of the polar encoded codeword to obtain one or more bits of the codeword, and performing early termination of the polar decoding based on a failure of at least one of the CRC bits or the at least one parity bit.

The details of one or more examples of implementations are set forth in the accompanying drawings and the description below. Other features will be apparent from the description and drawings, and from the claims.

BRIEF DESCRIPTION OF THE DRAWINGS

FIG. 1 is a block diagram of a wireless network according to an example implementation.
FIG. 2 is a diagram illustrating a 2-bit polar encoder according to an example implementation.
FIG. 3 is a diagram illustrating a 4-bit polar encoder according to an example implementation.
FIGs. 4 and 5 are diagrams illustrating construction of a codeword that includes information bits, distributed CRC (cyclic redundancy check) bits, and at least one distributed parity bit according to example implementations.
FIG. 6 is a diagram illustrating generation of parity bits for a codeword according to an illustrative example implementation.
FIG. 7 is a diagram illustrating an example generator matrix G according to an example implementation.
FIG. 8 is a flow chart illustrating channel encoding according to an example implementation.
FIG. 9 is a flow chart illustrating a method of performing channel decoding according to an example implementation.
FIG. 10 is a block diagram of a node or wireless station (e.g., network device, base station/access point or mobile station/user device/UE) according to an example implementation.

DETAILED DESCRIPTION

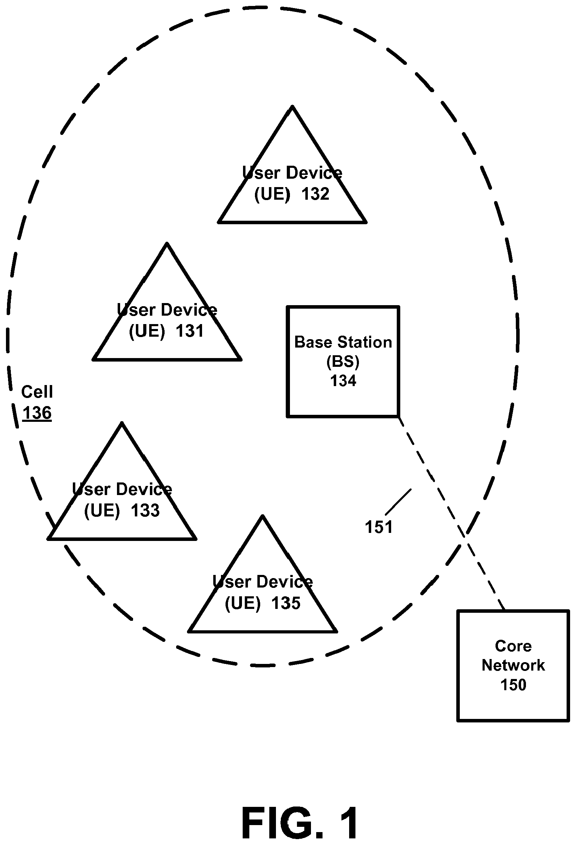

FIG. 1 is a block diagram of a wireless network 130 according to an example implementation. In the wireless network 130 of FIG. 1, user devices 131, 132, 133 and 135, which may also be referred to as mobile stations (MSs) or user equipment (UEs), may be connected (and in communication) with a base station (BS) 134, which may also be referred to as an access point (AP), an enhanced Node B (eNB) or a network node. At least part of the functionalities of an access point (AP), base station (BS) or (e)Node B (eNB) may be also be carried out by any node, server or host which may be operably coupled to a transceiver, such as a remote radio head. BS (or AP) 134 provides wireless coverage within a cell 136, including to user devices 131, 132, 133 and 135. Although only four user devices are shown as being connected or attached to BS 134, any number of user devices may be provided. BS 134 is also connected to a core network 150 via a S1 interface 151. This is merely one simple example of a wireless network, and others may be used.

A user device (user terminal, user equipment (UE) or mobile station) may refer to a portable computing device that includes wireless mobile communication devices operating with or without a subscriber identification module (SIM), including, but not limited to, the following types of devices: a mobile station (MS), a mobile phone, a cell phone, a smartphone, a personal digital assistant (PDA), a handset, a device using a wireless modem (alarm or measurement device, etc.), a laptop and/or touch screen computer, a tablet, a phablet, a game console, a notebook, and a multimedia device, as examples. It should be appreciated that a user device may also be a nearly exclusive uplink only device, of which an example is a camera or video camera loading images or video clips to a network.

By way of illustrative example, the various example implementations or techniques described herein may be applied to various user devices, such as machine type communication (MTC) user devices, enhanced machine type communication (eMTC) user devices, Internet of Things (IoT) user devices, and/or narrowband IoT user devices. IoT may refer to an ever-growing group of objects that may have Internet or network connectivity, so that these objects may send information to and receive information from other network devices. For example, many sensor type applications or devices may monitor a physical condition or a status, and may send a report to a server or other network device, e.g., when an event occurs. Machine Type Communications (MTC, or Machine to Machine communications) may, for example, be characterized by fully automatic data generation, exchange, processing and actuation among intelligent machines, with or without intervention of humans.

Also, in an example implementation, a user device or UE may be a UE/user device with ultra reliable low latency communications (URLLC) applications. A cell (or cells) may include a number of user devices connected to the cell, including user devices of different types or different categories, e.g., including the categories of MTC, NB-IoT, URLLC, or other UE category.

In LTE (as an example), core network 150 may be referred to as Evolved Packet Core (EPC), which may include a mobility management entity (MME) which may handle or assist with mobility/handover of user devices between BSs, one or more gateways that may forward data and control signals between the BSs and packet data networks or the Internet, and other control functions or blocks.

The various example implementations may be applied to a wide variety of wireless technologies or wireless networks, such as LTE, LTE-A, 5G, cmWave, and/or mmWave band networks, IoT, MTC, eMTC, URLLC, etc., or any other wireless network or wireless technology. These example networks or technologies are provided only as illustrative examples, and the various example implementations may be applied to any wireless technology/wireless network.

Polar codes are a new and promising channel coding scheme to approach communication channel capacity, which is a linear block code developed by Erdal Arikan. It is the first channel code with an explicit construction to achieve the capacity of symmetric binary-input, discrete, memoryless channels (BI-DMCs). Polar codes have comparable and sometimes even better performance to state-of-the-art codes like LDPC, meanwhile the decoding complexity of polar codes is as low as $O\,(LN \log N)$. Here $N$ is the encoded block length and L is the list size. These features make polar codes very attractive for many applications, like digital communications and storage.

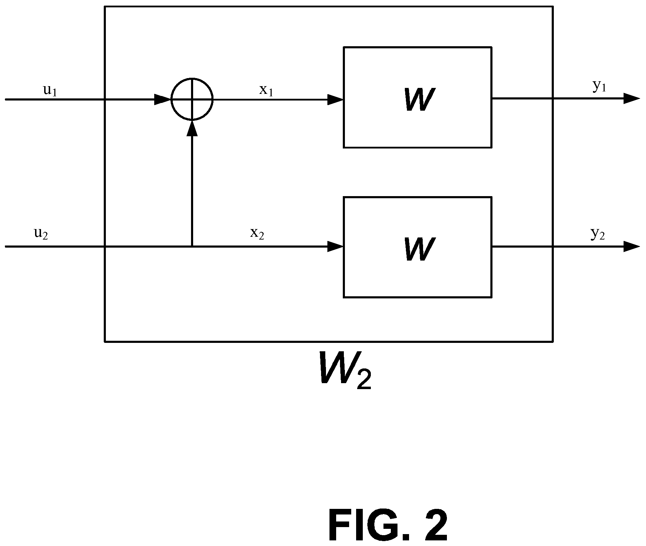

Polar codes are based on the concept of polarization. The basic building block in polar codes can be depicted shown in FIG. 2. FIG. 2 is a diagram illustrating a 2-bit polar encoder according to an example implementation. Here $u_i$ refer to the input bits of the encoder, and $y_i$ refer to the output/encoded bits of the encoder. It can be shown that in this configuration, the mutual information $I\,(U_1;\,Y_1,\,Y_2)$ decreases compared to the pre-polarized pair, $I\,(U_1;\,Y_1)$, while $I(U_2;\,Y_1,\,Y_2,\,U_1)$ increases compared to $I(U_2;\,Y_2)$. In this way, one channel (one bit channel) is degraded and the other channel/bit channel is upgraded. This phenomenon is called channel polarization. As shown in FIG. 2, $u_1$ and $u_2$ are information bits, where an XOR (exclusive OR or modulo-2 addition operation) is performed on information bits $u_1$ and $u_2$ to produce code bit x1, and $u_2$ is passed through (without any XOR operation) to produce code bit $x_2$. Code bits $x_1$ and $x_2$ are transmitted over channel W to provide received code bits (or encoded bits) $y_1$ and $y_2$, respectively. Two bit channels are shown in the two-bit polar encoder of FIG. 2, including a bit channel for bit $u_1$, and a bit channel for bit $u_2$. The channel capacity for bit channel for $u_2$ is increased or enhanced, while the channel capacity for the $u_1$ bit channel is decreased. Bit channel for bit $u_1$ is decreased due to $u_2$ interfering based on a XOR or modulo-2 addition of $u_1$ and $u_2$ to produce $x_1$. No interference occurs (or XOR operation occurs) for $x_2$, and thus, $u_2$ channel capacity is increased, resulting in a corresponding decrease in channel capacity for $u_1/x_1$ channel. This process may be repeated, to cause some channels to increase in capacity, and other channel to decrease in capacity, which causes polarization. For example, polar codes may be used to enhance channel capacity of one or more bit channels, while similarly decreasing channel capacities of one or more other bits channels. Data may then be transmitted over the enhanced (upgraded) channels (having increased channel capacities), and fixed values or frozen bits, e.g., zeros, may be transmitted over the decreased (degraded) channels.

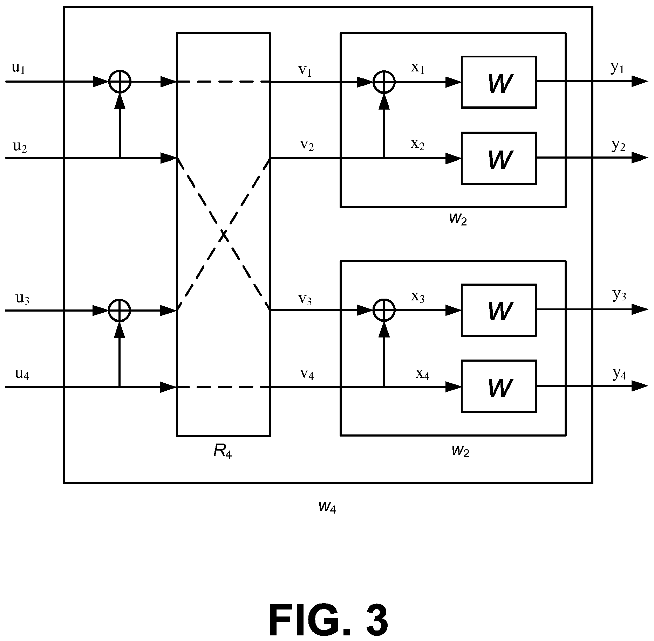

FIG. 3 is a diagram illustrating a 4-bit polar encoder according to an example implementation. By systematically replicating and stacking the basic blocks (e.g., see FIG. 2 for an example basic building block), longer polar codes can be constructed. For example, the FIG. 3 characterizes a length-4 polar code. R4 refers to a reverse shuffle of the inputs or permutation, e.g., with 4 inputs, 4 outputs. Two of the 2-bit polar encoders (basic building block for polar encoder) shown in FIG. 2, are included within this 4 bit polar encoder of FIG. 3, for example.

As shown in FIG. 3, the channel capacity (and thus, reliability) for input bit $u_4$ is enhanced twice based on absence of XOR operations between $u_4$ and $y_4$, resulting in a twice-enhanced channel at output bit $y_4$. Similarly, channel for input bit $u_1$ is decreased twice, e.g., based on first XOR operation with $u_2$, and then v1 XOR with $x_2$, to cause output bit $y_1$ to be twice decreased in channel capacity. Channels for $u_2$ and $u_3$ are in-between (being increased and decreased channel capacity).

As the number of layers grows up, the channels are kept being degraded and upgraded. In other words, the polarization effect becomes more and more visible. Eventually, some channels would have zero (or at least very low) capacity and the other channels would become error-free (or at least much higher capacity). Thus, for example, the bits transmitted over higher capacity channels may typically have higher reliability than bits transmitted over lower capacity channels. Based on the polar coding/encoding, a transmitting device may determine which bits to transmit on higher capacity (or higher reliability) channels, and which bits should be transmitted on lower capacity (or lower reliability) channels. For example, according to an example implementation, some fields of an information word may be deemed to be more critical or important, and thus, may be transmitted via higher capacity channels or higher reliability channels. For example, a CRC bit may be transmitted over the highest reliability bits/channels, or data, or other control information may be transmitted or prioritized for transmission over the highest reliability (or highest capacity) bits or channels, based on the polar encoding. The idea of polar codes is to choose the error-free (or more reliable) channels to transmit information bits or control information and force the value of the bits transmitted in the zero-capacity (or less reliable) channels to be some known or predetermined value, e.g., 0. These bits are called frozen bits, which may typically have predetermined values (e.g., zeros).

By choosing the $K$ best channels out of the total $N$ polarized channels, a rate $K/N$ polar code can be obtained. In the example shown in FIG. 3, $K = 2$ may be selected with $(u_3, u_4)$ as information bits, and $(u_1, u_2)$ as frozen bits. Effectively a polar code of rate 1/2 is constructed, in this manner, as an illustrative example.

A traditional approach to error detection and/or correction may typically include generating one or more cyclic redundancy (CRC) bits, and then appending the CRC bits to the end of a information block that include a plurality of information bits. Parity bits may also be generated and appended to the information block.

As noted, CRC bits may be generated and appended for use in error detection and/or correction. Parity bits may also be provided, and, e.g., used by a receiver for error correction.

Downlink control channel decoding is an energy consuming process for a user device/UE as it may typically include blind decoding and CRC check normally done after full information is decoded. In general, early termination may be considered important to reduce the energy consumption associated with the UE blind decodes and also to reduce the latency of overall decoding process. Early termination of decoding of a received encoded codeword may include terminating or stopping decoding of the encoded codeword before all information bits have been decoded.

According to an example implementation, use of CRC bits and parity bits within a codeword may be used to support or allow early termination of decoding of the codeword. A specific CRC bit is related (or derived from or based upon) only a subset of the information bits. For example, a first CRC bit may be derived from or based upon a group of four (e.g., the first four) received information bits in the codeword, and then a CRC check may be performed against the received CRC bit. A failed CRC check may cause the receiver/UE to terminate decoding of the codeword before all information bits have been decoded (early termination). Thus, in this illustrative example, for a codeword that includes 12 information bits and where early termination is based upon a failed CRC bit where 4 information bits are required to derive a CRC bit, this means that early termination of decoding for that codeword cannot be started until at least 4 of the 12 information bits (1/3 of the information bits of the codeword) have been decoded at the receiver. It may be desirable or advantageous (to provide a greater power savings or further reduction in latency) to allow even earlier termination of the decoding of the codeword, e.g., because, at least in some cases, errors in a codeword may occur and be detected very early if a technique (e.g., CRC bits or parity bits) are provided early enough in the codeword.

Therefore, according to an example implementation, a parity bit may be generated or derived based on only two (or more) other bits (e.g., at least two information bits, or at least an information bit and a CRC bit, as examples). For example, at least one parity bit may be determined or derived based on a subset of the information bits located prior to the end of the codeword, and also where the parity bit(s) are located prior to the end of the codeword to support early termination of decoding. A CRC bit and a parity bit may be generated from a set of information bits, and these information bits may be less than a full set of information bits (or less than a full information block within a codeword). Thus, a CRC bit or parity bit may be determined or generated from a subset of bits that are located prior to the end of the codeword (e.g., a subset of information bits that may be located at or near the beginning of the codeword, for example). Therefore, by providing one or more parity bits early in the codeword (e.g., before a first CRC bit), it may be possible to support an early termination. Thus, according to an example implementation, at least in some cases, providing at least one parity bit early within a codeword may allow an earlier termination than what might be supported by using only CRC bits, e.g., because a parity bit, at least in some examples, may be derived from or based upon fewer bits as compared to a CRC bit.

According to an example implementation, e.g., in order to support or facilitate early (or earlier) termination of decoding at a receiver/receiving UE, both a plurality of CRC bits and at least one parity bit, which are located prior to the end of the codeword, may be provided for a codeword, wherein the CRC bits and the at least one parity bit may be distributed among the plurality of information bits of the codeword. Thus, the codeword may include information bits, a plurality of CRC bits, and at least one parity bit. Also, each of the plurality of CRC bits and the at least one parity bit may be derived or determined from only a subset of the information bits of the codeword. The subset of information bits (which may be used to derive a CRC bit and/or the parity bit(s)) may also be provided prior to the end of the codeword, e.g., to allow a user device/receiver to detect an error early (earlier) in the decoding process and termination decoding before all information bits of the codeword have been decoded. After the codeword has been determined (e.g., including information bits, a plurality of CRC bits and at least one parity bit), polar encoding may be performed on the codeword to obtain a polar encoded codeword. The polar encoded codeword may then be transmitted (e.g., either uplink or downlink) to a receiver/receiving device (e.g., either UE or BS/eNB).

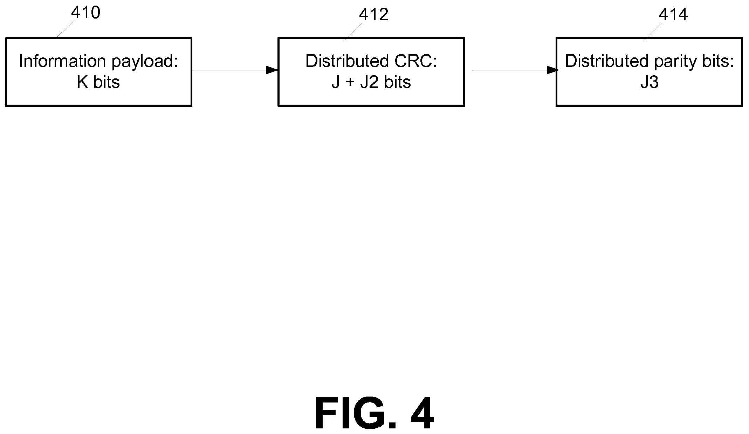

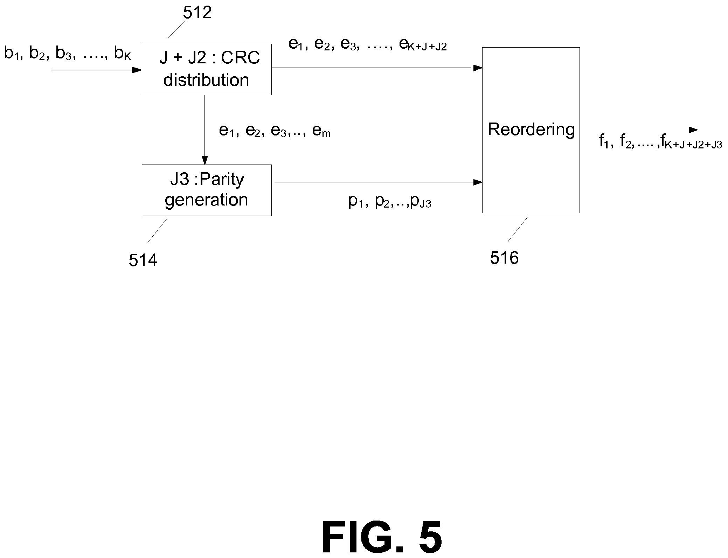

FIGs. 4 and 5 are diagrams illustrating construction of a codeword that includes information bits, distributed CRC (cyclic redundancy check) bits, and at least one distributed parity bit according to example implementations. Referring to FIG. 4, at 410, K information bits are received for transmission (K information bits within a codeword). At 412, J bits of CRC may be used for error detection, J2 CRC bits may be used for error correction. At 414, J3 parity bit(s) may be used for error correction. Altogether, J + J2 CRC bits and J3 parity bits can be used for early termination of the decoding of the codeword at a receiver/receiving device.

An illustrative problem may arise where a first CRC bit may be generated, e.g., after 1/3 of information bits have been transmitted (or based on the first 1/3 of the information bits of the codeword). Thus, for example, if there are 12 information bits in a codeword, and if a first CRC bit may be generated based on, e.g., the first 4 information bits, then this means (by way of illustrative example) that the receiver cannot perform early termination of the decoding of this codeword until at least the first 4 information bits and the first CRC bit have been received and decoded by the receiver/receiving device (thereby allowing a CRC check to be performed for these information bits against the received CRC bit). Thus, a failed CRC check for a first CRC bit may cause the receiver, for example, to perform early termination of the decoding of the codeword after decoding these 4 information bits and the first CRC bit, according to this illustrative example. For example, early termination of decoding may include terminating or stopping/discontinuing decoding of a codeword before all information bits have been decoded. For example, a CRC bit may be generated based on at least 4 bits, in this illustrative example, which may limit how early termination may be performed by the receiver based on a failed CRC check for this first CRC bit, for example.

In some cases, it may be desirable to allow a receiver/receiving device to terminate decoding even earlier, and providing one or more parity bits, e.g., early within the codeword, may allow an earlier termination (by a receiver) of the decoding of the codeword than what may be possible by using only CRC bits. According to an example implementation, CRC bits and one or more parity bits may be distributed within the codeword, and provided prior to the end of the codeword (rather than being appended to the end of the information bits or at the end of the codeword). According to an example implementation, to support early termination of decoding, a parity bit may be provided or allocated to a position within the codeword before (or prior to) the first CRC bit, and the parity bit may be generated based on a subset (e.g., only 2 bits) of the information bits upon which the first CRC bit is generated. Other parity bits may similarly be provided and allocated to distributed positions within the codeword.

According to an example implementation, each of the distributed parity bits may be generated independently (e.g., generated only based on information bits, not CRC bits) from the CRC bits and do not have to depend on the full info block. A parity bit may be generated based only on multiple (e.g., two or more) information bits, or may be generated based on one or more CRC bits (e.g., based on a CRC bit and an information bit).

According to an example implementation, to perform channel decoding or polar decoding, a receiver or wireless receiving device may include or implement a list decoder (e.g., such as a successive cancellation list decoder). In list decoding, the receiver or decoder generates a list or tree of possible message outputs, and one or more candidate paths in the tree or list may be pruned or trimmed (some entries or candidates paths of the list will be deleted) to limit the number of candidate paths so as to limit computational complexity. For example, a metric for each candidate path may be determined, and the candidate paths with a metric less than a threshold may be pruned or deleted from the list. Furthermore, according to an example implementation, a failed CRC check (e.g., where a CRC bit calculated at a receiver does not match a received CRC bit) and/or a failed parity check (e.g., where a calculated parity bit does not match a received parity bit) may cause the receiver to prune those candidate paths that depended upon one or more information bits upon which the failed CRC or parity bit was based. In some cases, for example, a failed CRC check or a failed parity check may cause the receiver to terminate (e.g., perform early termination of) the decoding of the codeword (e.g., in the case where all candidate paths fail based on failed CRC check or failed parity check).

Therefore, according to an example implementation, one or more distributed parity bit(s) may provide early tree pruning opportunities and/or support the early termination of decoding at the receiver. Moreover, an attachment of parity bits and/or CRC bits may be done in such a way that it improves the code construction (e.g., by assigning CRC bits and/or parity bits to entries or positions within a polar encoder or polar encoding matrix that have lower row weight to thereby increase independence of such CRC and/or parity bits within the codeword).

Further example details of generating a codeword for polar encoding are illustrated in FIG. 5.

  b - information bits (information block)
  e - CRC plus information encoded bits (includes both information bits and CRC bits)
  p - parity bits -e.g., for error correction and early termination (e.g., both CRC bits and parity bits may be used for early termination).

At CRC distribution block 512, information bits b (e.g., $b_1$, $b_2$, ...) are received, and one or more CRC bits are generated based on one or more subsets of the information bits. E.g., a CRC bit may be generated based on less than all of the information bits. For example, a first CRC bit may be generated based on a first 4 information bits. Encoded bits e (which may include information bits b and CRC bits), such as $e_1$, $e_2$, $e_3$, ... are output from CRC distribution block 512 to reordering block 516, and at least some (or a portion) of the encoded bits e are output to a parity generation block 514.

Thus, according to an example implementation, at CRC distribution block 512, CRC generation and distribution of bits is performed for the information block $[b_1, b_2, b_3, ..., b_K]$ with single J + J2 CRC generator or two stage, J CRC and J2 CRC, CRC generators. The encoded block or the CRC distributed code, output by CRC distribution block 512, is denoted as $[e_1, e_2, e_3, ..., e_{K+J+J2}]$.

Parity generation block 514 generates one or more parity bits p, e.g., which may include one or more of parity bits $p_1$, $p_2$, $p_3$, ... For example, a subset of the code bits e (e.g., 1/3 or ½ of e bits of code block) may be output to parity generation block 514.

For example, first and second CRC bits may typically over a large portion of the information block, thus, it is sufficient to feed associated information bits to generate sufficient number of parity bits (which may not allow an early or earlier termination of decoding at the receiver, e.g., if the CRC bits or parity bits are base on information bits located or positioned later in the codeword). In general, the first n CRC bits and relevant information bits, $[e_1, e_2, ..., em]$, may be used to generate J3 parity bits. Generated parity bits are denoted as $[p_1, p_2, ..., p_{J3}]$. However, by front loading (e.g., see reordering block 516 to reorder bits of the codeword) one or more (or even all) of the parity bits early within the codeword, such as, e.g., within or before the first CRC bit, this may allow an even earlier termination of decoding at a receiver (e.g., based on a failed parity check) than what may otherwise be possible by using only CRC bits.

Reordering block 516 may receive encoded bits e (including information bits and CRC bits) and parity bits p, and may reorder these bits and output a codeword that includes bits f, such as f1, f2, f3, ... For example, bits (information bits, CRC bits and/or parity bit(s)) may be reordered or positioned within the codeword such that, e.g., at least some CRC bits and/or some or all of the parity bits are front loaded within the codeword or positioned within a first subset of the information bits, e.g., to support early termination of decoding based on a failed CRC check and/or failed parity check. For example, CRC bits may be distributed throughout the codeword, while all (or at least some) of the parity bits may be positioned or located within or before the first CRC bit of the codeword, e.g., to allow parity check to be performed at the receiver based on, e.g., the first two information bits and a received first parity bit), which may support an early termination of decoding. This is merely one illustrative example of an early termination of decoding based on a parity check, and other examples of early termination may be provided or used.

According to an example implementation, after reordering block 516 reorders the information bits, CRC bits and/or parity bits, one or more frozen bits with predetermined values (e.g., zeros) may be added to the codeword, and then polar encoding may be performed at the transmitter on the codeword to generate a polar encoded codeword. For example, polar encoding may be performed by multiplying the codeword output by reordering block (e.g., after frozen bits have been added) by a polar encoding matrix, which may be referred to as a generator matrix, for example.

Thus, according to an example implementation, the J3 parity bits are then input to reordering block 516 with CRC distributed code (b bits - information and CRC bits) in such a way that parity bits are mapped together with associated information bits and CRC bits, e.g., to specific rows or locations of a polar encoder or polar matrix. For example, the information bits, CRC bits and parity bits may be mapped (e.g., by reordering block 516) to more reliable rows or positions of a polar encoder or polar encoding matrix, while one or more frozen bits may be mapped to rows or bit positions of the polar encoder or polar encoding matrix that are less reliable.

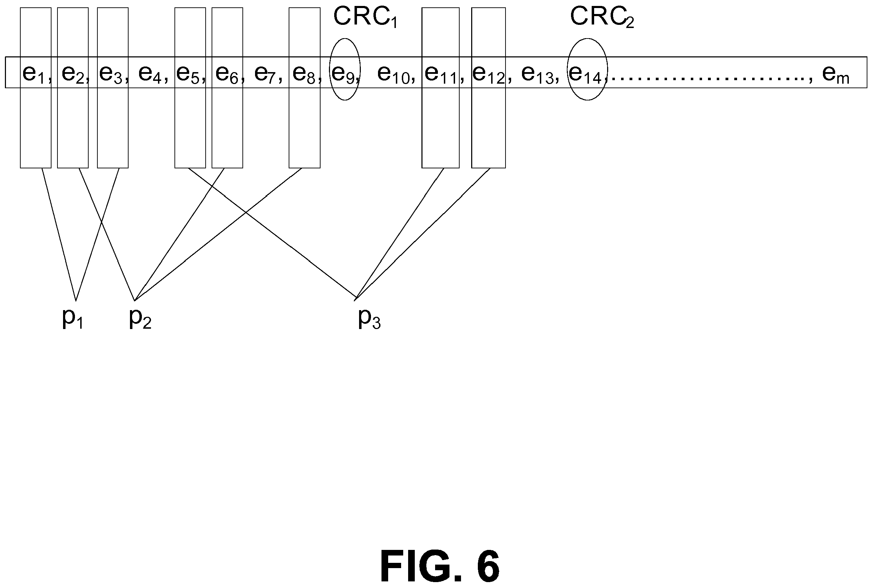

FIG. 6 is a diagram illustrating generation of parity bits for a codeword according to an illustrative example implementation. As noted, encoded bits e ($e_1$, $e_2$, $e_3$, $e_4$,...$e_m$) may include information bits and CRC bits. Each CRC bit may have been generated based on a (e.g., different) subset of information bits. As shown in FIG. 6, m encoded bits (or e bits) are shown, including $e_1$, $e_2$, ...$e_{14}$... $e_m$. In this illustrative example, within the first 14 encoded (or e) bits, bits $e_9$ ($CRC_1$) and $e_{14}$ ($CRC_2$) are CRC bits, and the remaining e bits (within these first 14 e bits) are information bits, for example. In an illustrative example, $e_9$ (which is the first CRC bit, $CRC_1$) may be generated based on encoded bits $e_1$ - $e_8$ (or some subset thereof). The second CRC bit at e14 ($CRC_2$) may be generated based on, for example, encoded bits $e_{10}$-$e_{13}$ (or some subset thereof), for example.

Also, referring to FIG. 6, one or more (or even all) of the parity bits p of a codeword may be generated or determined based on a plurality of information bits upon which the first CRC bit ($CRC_1$) is generated or derived. Some of the later parity bit(s) may be generated based on information bits upon which a later CRC bit (e.g., $CRC_2$ or $CRC_3$) is determined. A parity bit may be based on multiple information bits, or based on a CRC bit(s) and one or more information bits (e.g., a combination of information and parity bits).

Referring to the illustrative example of FIG. 6, parity bit $p_1$ is determined or based upon encoded bits $e_1$ and $e_3$; parity bit $p_2$ is determined or based upon encoded bits $e_2$, $e_6$ and $e_8$; and, parity bit $p_3$ is determined or based upon encoded bits $e_5$, $e_{11}$ and $e_{12}$. Thus, in this example, parity bits $p_1$ and $p_2$ may be derived or based upon the information bits (or subset thereof) upon which the first CRC bit ($CRC_1$, provided at $e_9$) is derived, and the parity bits $p_1$ and $p_2$ are located at a position before or prior to the first CRC bit.

A number of possible scenarios or example implementations, such as, e.g.,:

1) When the number of parity bits is limited (e.g., one or two parity bits), the parity bits can be allocated prior to the first CRC bit. Parity bits may be generated based on the information bits that are associated with the first CRC bit (e.g., for example, all parity bits may be generated based on information bits used to generate a first CRC bit). In an illustrative example, an information block (a no. of information bits) may be, e.g., 12 - 120 information bits or payload for downlink control information (DCI), and 12-500 information bits or payload for uplink control information (UCI), for example. Parity bits may vary between 1 and 8 parity bits, and CRC bits, for example, between 16 - 20 CRC bits for downlink (DL) information; and 8-12 CRC bits for uplink (UL) control. In this example, two parity bits may be generated based on bits 1-9 - front loaded based on information bits used to generate first CRC bit. For example, an error may appear early in the codeword, and it may thus be desirable to terminate decoding of this codeword early (as early as possible), and the error may, at least in some cases, be detected with parity check, causing the receiver to terminate or discontinue decoding other bits of received codeword (encoded code block plus which includes info bits, CRC bits, plus parity bits). CRC generation may typically require more bits, and thus a CRC bit may typically be provided or located later in the codeword (e.g., a first CRC bit may typically occur after one or more parity bits, according to an example implementation). For example, it may not be possible to move CRC bits earlier in the codeword because, e.g., CRC bits may require a minimum number of information bits, e.g., 4, to generate a CRC bit. Whereas, according to an example implementation, a parity bit may be based on as few as, e.g., two bits. Thus, a parity check, as a technique to detect an error, can occur much earlier in decoding (earlier within a codeword), thus can be used to perform an earlier termination of decoding of the codeword, for example.

2) According to an illustrative example, when the number of parity bits are higher (e.g., three or more parity bits), the parity bits can be generated in an independent (based only on information bits) or dependent (based on at least one CRC bit or other parity bit) manner. For example, the second parity bit can also receive a first parity bit as an input to generate the parity (in this case, the second parity bit may be generated in a dependent manner, since it depends on a CRC bit or another parity bit).

3) When a parity check (for a parity bit) passes at a receiver, decoding can be continued by pruning this list based on other criteria; if parity check fails, then the receiver may prune the tree of list decoder based on parity, e.g., if all paths have failed, then decoding may be terminated based on failed parity check; if only some paths have failed based on failed parity check, then prune those failed paths from list of list decoder. Also, CRC or parity bit may be checked when relevant information bits are decoded by the successive cancelation list decoder. A parity bit may be a decision criteria for how different paths are pruned (i.e., pruning the tree), so if a parity bit check fails, then the receiver would prune or eliminate those candidate paths, and might terminate the decoding if all paths fail the parity check, as some illustrative examples. For example, for a given path, the receiver/decoder has decoded information bits 1001, then if a parity bit for any of those decoded information bits fails, then the candidate path(s) based on any of those information bits also fails and those candidate paths may/should be pruned, for example. Thus, a parity check may be used to terminate decoding at a receiver/receiving device.

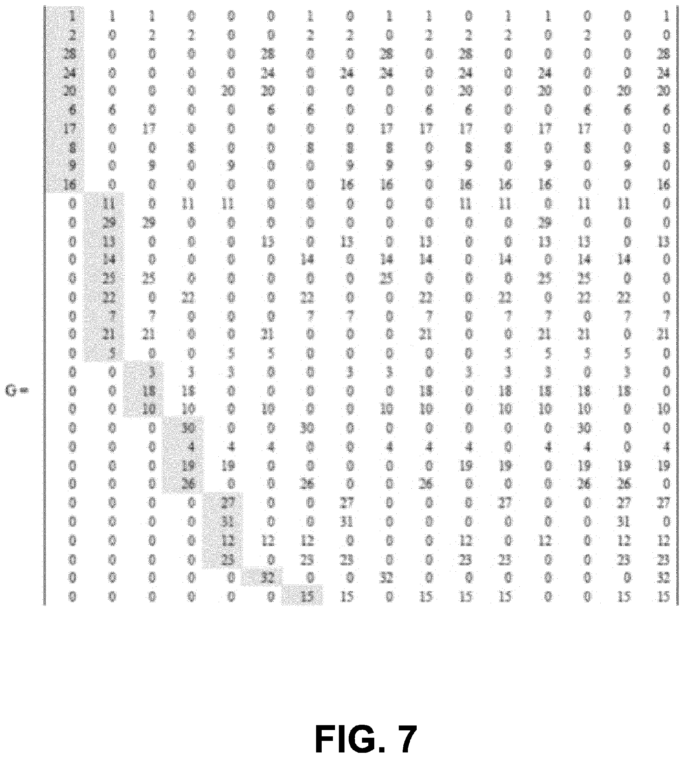

4) Parity bits and CRC bits can be allocated to the positions that polar encoding matrix (e.g., Kronecker matrix), which is like G matrix (e.g., FIG. 7), has lower row weights in order to improve the code construction. Row weight may be based on a number of ones (1s) in the row of the polar encoding matrix. More ones (indicating a greater row weight) for a row indicates greater mixing for that bit with other bits (and more dependence on other bits). It may be desirable, for code construction purposes, to maintain greater independence of assistant bits (CRC bits and/or parity bits) of a codeword. Hence, according to an example implementation, assistant bits (e.g., CRC bits and/or parity bits) may be assigned to bit (or row) positions in an polar encoder/polar encoding matrix that have lower row weights (among the row or bits positions that have high reliability or high channel capacity), or even the lowest row weights to provide less mixing of CRC and/or parity bits with other bits, and thus, provide greater independence of the CRC bits and/or parity bits after polar encoding. The allocation of the information bits, CRC bits and parity bits can be done as follows, by way of illustrative examples:

Polar encoding using a polar encoding matrix, e.g., a Kronecker matrix

The following two cases may be provided as examples:

1. Prioritize the performance of the code while providing sufficient level of early termination. (case 1)
2. Prioritized the early termination performance while satisfying good code property. (case 2)

These example implementations of a polar encoder/polar encoding matrix are used or provided to illustrate ways or techniques that may be used to allocate the most reliable positions to information and assistant bits (CRC bits and/or parity bits).

The following discussion (e.g., examples for case 1 and case 1) may assume, for example: assumed K = 8 (information bits), M=N=16 (no. of encoded bits after polar encoding), and the number of assistant bits (parity + CRC) = 3 bits (e.g., which may include 2 CRC bits and parity bit.

K - is information bits; M - no. of encoded bits after polar encoding; N - is polar mother codeword size, by way of illustrative example.

Table 1 below is a polar encoding matrix, or a polar generator matrix (e.g., a Kronecker matrix) - a 16x16 matrix - that may be used to perform polar encoding.

Case 1: Allocation of frozen bits on least reliable positions/rows of matrix (upper 5 rows); allocation of information bits and assistant bits (CRC and parity bits) on highest reliable positions/rows; (bottom 11 rows); and assistant bits (CRC and parity bits) are allocated to positions that have lower or lowest row weight of polar generator matrix (within higher/highest reliable positions/rows) is allowed.

Table 1 - Example Polar Encoding Matrix for case 1

| | | | | | | | | | | | | | | | |
|---|---|---|---|---|---|---|---|---|---|---|---|---|---|---|---|
| Frozen 1 | 0 | 0 | 0 | 0 | 0 | 0 | 0 | 0 | 0 | 0 | 0 | 0 | 0 | 0 | 0 |
| Frozen 1 | 1 | 0 | 0 | 0 | 0 | 0 | 0 | 0 | 0 | 0 | 0 | 0 | 0 | 0 | 0 |
| Frozen 1 | 0 | 1 | 0 | 0 | 0 | 0 | 0 | 0 | 0 | 0 | 0 | 0 | 0 | 0 | 0 |
| Frozen 1 | 0 | 1 | 0 | 0 | 0 | 0 | 0 | 0 | 0 | 0 | 0 | 0 | 0 | 0 | 0 |
| Frozen 1 | 0 | 1 | 0 | 0 | 0 | 0 | 0 | 0 | 0 | 0 | 0 | 0 | 0 | 0 | 0 |
| f1Info 1 | 1 | 1 | 1 | 0 | 0 | 0 | 0 | 0 | 0 | 0 | 0 | 0 | 0 | 0 | 0 |
| f2Info 1 | 0 | 0 | 0 | 1 | 0 | 0 | 0 | 0 | 0 | 0 | 0 | 0 | 0 | 0 | 0 |
| f4Info 1 | 1 | 0 | 0 | 1 | 1 | 0 | 0 | 0 | 0 | 0 | 0 | 0 | 0 | 0 | 0 |
| f3assist 1 | 0 | 1 | 0 | 1 | 0 | 1 | 0 | 0 | 0 | 0 | 0 | 0 | 0 | 0 | 0 |
| f5Info 1 | 1 | 1 | 1 | 1 | 1 | 1 | 1 | 0 | 0 | 0 | 0 | 0 | 0 | 0 | 0 |
| f7assist 1 | 0 | 0 | 0 | 0 | 0 | 0 | 0 | 1 | 0 | 0 | 0 | 0 | 0 | 0 | 0 |
| f6Info 1 | 1 | 0 | 0 | 0 | 0 | 0 | 0 | 1 | 1 | 0 | 0 | 0 | 0 | 0 | 0 |
| f8assist 1 | 0 | 1 | 0 | 0 | 0 | 0 | 0 | 1 | 0 | 1 | 0 | 0 | 0 | 0 | 0 |
| f9Info 1 | 1 | 1 | 1 | 0 | 0 | 0 | 0 | 1 | 1 | 1 | 1 | 0 | 0 | 0 | 0 |
| f10Info 1 | 0 | 0 | 0 | 1 | 0 | 0 | 0 | 1 | 0 | 0 | 0 | 1 | 0 | 0 | 0 |
| f11Info 1 | 1 | 0 | 0 | 1 | 1 | 0 | 0 | 1 | 1 | 0 | 0 | 1 | 1 | 0 | 0 |
| f12Info 1 | 0 | 1 | 0 | 1 | 0 | 1 | 0 | 1 | 0 | 1 | 0 | 1 | 0 | 1 | 0 |
| f13info 1 | 1 | 1 | 1 | 1 | 1 | 1 | 1 | 1 | 1 | 1 | 1 | 1 | 1 | 1 | 1 |

In this example (case 1), there is increasing reliability from top to bottom for example, within Table 1. Thus, for example, the top row may be the least reliable (allocated to a frozen bit), and the lowest row may be the most reliable bit position or row. Thus, the more or most reliable (highest reliability) bit positions within matrix of Table 1 are the lower 11 rows. The example reliabilities for the rows of the precoding matrix in Table 1 are merely one illustrative example, and reliabilities may occur or may be provided in a precoding matrix in any order. Bits f3 and f8 are each assigned or allocated to a row that has a row weight of 4 (only four 1s in these two rows), whereas bit f7 is a assigned to a row with a row weight of 2 (only two 1s in this row). By assigning or allocating (or mapping) the assistant bits (CRC bits and/or parity bits) to rows or bit positions of the polar encoder/polar encoding matrix of Table 1 that have a lower row weight than (e.g., some or all) the rows or bit positions that are mapped to information bits. In some cases of polar encoding, a lower row weight may indicate less mixing of this bit with other bits as part of the polar encoding. Thus, a row with a lower row weight (e.g., fewer 1s in that row of the polar encoding matrix) may provide a more independent bit that is output from the polar encoding. In some cases, it may be desirable, or may be advantageous, for one or more of the assistant bits (CRC bits, parity bits) to remain more independent. Thus, there may be advantages, at least in some cases, to mapping one or more assistant bits to a row having a lower row weight, which in some cases, may improve or may be perceived by some as improving the polar code construction, for example.

However, this improved code construction of the example shown in Table 1 may be achieved with a cost of a slightly delayed early termination. According to an illustrative example, after the assistant bits, e.g., f3, f7 and f8, are allocated to the lowest row weights as shown in Table 1, the information bits are allocated in order from top to bottom of the more reliable bit positions, according to an illustrative example. Thus, assistant bits may be allocated to bit positions of the polar encoding matrix having lowest row weight to improve code performance, and by slightly sacrificing early termination performance.

According to an example implementation, bits of the polar encoded codeword may be decoded in order, from top to bottom of matrix of Table 1. Thus, the decoder may first decode the frozen bits (less reliable rows/positions), and then decode the least reliable to most reliable bits (top to bottom) of the more reliable rows/positions. Thus, in the example of case 1 (shown by Table 1), the receiver may decode bits f1, f2 and then f4, and then f3. So, while assistant (e.g., parity) bit f3 is based only on bits f1, f2, the decoder will have to wait 1 bit more to receive f3, so an earliest termination is delayed by 1 bit in this example (e.g., receiver cannot terminate decoding until bits f1, f2, f4 and f3 have been received, thus after 3 information bits and 1 assistant bit have been received). In this manner, an early (earlier) termination is still supported by using an early assistant (e.g., early parity) bit at position f3, but this early termination has been slightly delayed by one bit to allow assistant bits to be allocated to rows/positions having a lower row weight, e.g., which may, at least in some cases, improve polar code performance via more independent assistant bits (e.g., this is why bits f3 and f4 are out of order in Table 1, according to this illustrative example).

Thus, in the case of Table 1, the polar encoding is represented by the Kronecker matrix of Table 1. For polar encoding, it may be useful or desirable for the information bits and frozen bits to be mixed (via allocation rows/positions having higher row weights, thereby causing greater polarization for frozen vs. information bits), e.g., as much as possible, but have the assistant bits allocated to rows or bit positions that have a lower or lowest row weight in the matrix of Table 1 (e.g., to improve code performance via improved independence (e.g., which may include less mixing with other bits during polar encoding) of the assistant bits).

Table 2 below is a polar encoding matrix, or a polar generator matrix (e.g., a Kronecker matrix) - a 16x16 matrix - that may be used to perform polar encoding according to another example implementation.

<u>Case 2</u>: Allocation of non-frozen bits, (information bits and assistant bits) on highest reliable positions and allocation of the non-frozen bits (information bits and/or or assistant bits) on lower row weight positions of the polar generator matrix (within higher reliable places) is allowed. In this example, the objective is early (or earlier) termination of decoding, and improved code performance is not achieved since assistant bits are not specifically required to be assigned to the lowest row weights within the higher reliability bit positions or rows. Thus, the example allocation of bits to rows/positions of the polar encoding matrix of Table 2 is designed to improve early (or provide earliest) termination of decoding.

Table 2 - Example Polar Encoding Matrix for case 2

| | | | | | | | | | | | | | | | |
|---|---|---|---|---|---|---|---|---|---|---|---|---|---|---|---|
| Frozen 1 | 0 | 0 | 0 | 0 | 0 | 0 | 0 | 0 | 0 | 0 | 0 | 0 | 0 | 0 | 0 |
| Frozen 1 | 1 | 0 | 0 | 0 | 0 | 0 | 0 | 0 | 0 | 0 | 0 | 0 | 0 | 0 | 0 |
| Frozen 1 | 0 | 1 | 0 | 0 | 0 | 0 | 0 | 0 | 0 | 0 | 0 | 0 | 0 | 0 | 0 |
| Frozen 1 | 1 | 1 | 1 | 0 | 0 | 0 | 0 | 0 | 0 | 0 | 0 | 0 | 0 | 0 | 0 |
| Frozen 1 | 0 | 0 | 0 | 1 | 0 | 0 | 0 | 0 | 0 | 0 | 0 | 0 | 0 | 0 | 0 |
| f1 I/A 1 | 1 | 0 | 0 | 1 | 1 | 0 | 0 | 0 | 0 | 0 | 0 | 0 | 0 | 0 | 0 |
| f2 I/A 1 | 0 | 1 | 0 | 1 | 0 | 1 | 0 | 0 | 0 | 0 | 0 | 0 | 0 | 0 | 0 |
| f3 I/A 1 | 1 | 1 | 1 | 1 | 1 | 1 | 1 | 0 | 0 | 0 | 0 | 0 | 0 | 0 | 0 |
| f4 I/A 1 | 0 | 0 | 0 | 0 | 0 | 0 | 0 | 1 | 0 | 0 | 0 | 0 | 0 | 0 | 0 |
| f5 I/A 1 | 1 | 0 | 0 | 0 | 0 | 0 | 0 | 1 | 1 | 0 | 0 | 0 | 0 | 0 | 0 |
| f6 I/A 1 | 0 | 1 | 0 | 0 | 0 | 0 | 0 | 1 | 0 | 1 | 0 | 0 | 0 | 0 | 0 |
| f7 I/A 1 | 1 | 1 | 1 | 0 | 0 | 0 | 0 | 1 | 1 | 1 | 1 | 0 | 0 | 0 | 0 |
| f8 I/A 1 | 0 | 0 | 0 | 1 | 0 | 0 | 0 | 1 | 0 | 0 | 0 | 1 | 0 | 0 | 0 |
| f9 I/A 1 | 1 | 0 | 0 | 1 | 1 | 0 | 0 | 1 | 1 | 0 | 0 | 1 | 1 | 0 | 0 |
| f10 I/A 1 | 0 | 1 | 0 | 1 | 0 | 1 | 0 | 1 | 0 | 1 | 0 | 1 | 0 | 1 | 0 |
| f11 I/A 1 | 1 | 1 | 1 | 1 | 1 | 1 | 1 | 1 | 1 | 1 | 1 | 1 | 1 | 1 | 1 |

Table 2 is similar to Table 1. This includes 5 frozen bits are allocated to or mapped to the least reliable bit positions, and the encoded bits (information bits and assistant bits, indicated by I/A) are mapped to or allocated to the 11 most reliable bit positions or rows (the lower 11 rows). And, like Table 1, there are 3 assistant bits, and 8 information bits for Table 2, according to these illustrative examples.

Also, for both Table 1 and Table 2, the bits in each row of the polar encoding matrix represent how this bit combines (or mixes) with other bits to perform polar codeword (e.g., via XOR operations of polar encoding).

In matrix of Table 2, the assistant bits are not necessarily allocated to the rows or bit positions having a lowest row weight. Rather, information and assistant bits (I/A bits) are or may be assigned to or mapped to rows or positions having a lowest row weight within the highest reliability bit positions (within the lower 11 rows). Thus, for example, information bits may be assigned or mapped to f1 and f2, and then a parity bit may be allocated or mapped to row position f3, where parity bit f3 is based on or derived from bits f1 and f2. Thus, in this example of matrix of Table 2, the bits are decoded at the receiver (after decoding the frozen bits), in the following order (least reliable to most reliable): f1, f2, f3, f4, f5, ...f11, and these I/A (information/assistant) bits may be allocated to mapped to the 11 highest reliability rows. Therefore, this approach of matrix of Table 2, that allows both information and assistant bits to be allocated or mapped to the lowest row weight positions or rows of the matrix, the earliest (or an earlier) termination of decoding may be achieved at a receiver, e.g., because assistant (e.g., parity) bit f3 may be received at the receiver immediately after receiving f1 and f2, which may, for example, allow the receiver to perform a parity check for parity bit f3 based on receiving only two information bits (f1, f2) in this example.- Whereas, as compared to Table 2, a slight delay of one additional bit may be experienced in terminating decoding at the receiver when using the mapping or bit allocation of the polar encoding matrix of Table 1, but this slight delay provided by Table 1 may provide or allow a slightly improved code performance, as described above.

Example of CRC and parity distribution

FIG. 7 is a diagram illustrating an example generator matrix G (only the check portion related to CRC and/ or parity).

A detailed example with 16 information bits, 16 CRC, polynomial [1 0 0 0 1 0 0 0 0 0 0 1 0 0 0 0 1], bits for error detection and correction, and 4 parity bits for error correction is considered below. The corresponding generator matrix 700, shown in FIG. 7, (only check part) for 16 is denoted as G. Row swapping and/ column swapping may be used to obtain this matrix. To identify the distribution, only the row/column swapped version only check part) is presented in FIG. 7. Here, in the matrix 700 shown in FIG. 7, relevant bit indexes are mentioned in the indicated numbers. There may be a CRC bit generated for each column of the matrix 700.

An example CRC distributed code (e.g., such as the e bits output by block 512, FIG. 5) may be illustrated as below.

$$
\begin{aligned}
e = [\ &1 \quad 2 \quad 28 \quad 24 \quad 20 \quad 6 \quad 17 \quad 8 \quad 9 \quad 16 \\
&\mathbf{C1} \quad 11 \quad 29 \quad 13 \quad 14 \quad 25 \quad 22 \quad 7 \quad 21 \quad 5 \quad \mathbf{C2} \quad 3 \\
&18 \quad 10 \quad \mathbf{C3} \quad 30 \quad 4 \quad 19 \quad 26 \quad \mathbf{C4} \quad 27 \quad 31 \quad 12 \quad 23 \\
&\mathbf{C5} \quad 32 \quad \mathbf{C6} \quad 15 \quad \mathbf{C7} \quad C8 \quad C9 \quad C10 \quad C11 \quad C12 \quad C13 \\
&C14 \quad C15 \quad C16\ ]
\end{aligned}
$$

Thus, looking at the first column of the generator matrix 700, CRC bit C1 may be determined or derived from (after receiving) bits (or bit positions) 1, 2, 28, 24, 20, 6, 17, 8, 9 and 16. CRC2 may be derived based on (or after receiving) bits 11, 29, 13, 14, 25, 22, 7, 21 and 5. CRC3 may be derived or determined from bits 3, 18 and 10. C4 may be determined based on bits 30, 4 19, 26. Etc.

Next, generation of parity bits (e.g., see block 514, FIG. 5) can be done as follows, by way of example:

- P1 = from 1,2,28
- P2 = from 24, 20, 8
- P3 = from 17, 9, 16, 29
- P4 = from 11, 14, 22, 7

After reordering of bits (same as, or similar to, what was shown or described for reordering block 516 shown in FIG. 5), codeword (e.g., f bits output by reordering block 516, FIG. 5) at the input of the polar encoder becomes,

$$
\begin{aligned}
f = [\ &1 \quad 2 \quad 28 \quad P1 \quad 24 \quad 20 \quad 6 \quad 17 \quad 8 \\
&P2 \quad 9 \quad 16 \quad C1 \quad 11 \quad 29 \quad P3 \quad 13 \quad 14 \quad 25 \quad 22 \\
&7 \quad P4 \quad 21 \quad 5 \quad C2 \quad 3 \quad 18 \quad 10 \quad C3 \quad 30 \quad 4 \quad 19 \\
&26 \quad C4 \quad 27 \quad 31 \quad 12 \quad 23 \quad C5 \quad 32 \quad C6 \quad 15 \quad C7 \\
&C8 \quad C9 \quad C10 \quad C11 \quad C12 \quad C13 \quad C14 \quad C15 \quad C16\ ]
\end{aligned}
$$

Thus, for example, first parity bit P1 may be determined based on only three information bits (1, 2, 28), which may allow a much earlier termination as compared to waiting to receive and decode all the information bits required for first CRC bit (C1).

When mapping these bits to the polar encoder, mapping from lower to higher reliability can be assumed within non-frozen positions. For lower row weights within the non-frozen bit positions, the nearest parity bit or CRC bit can be allocated to improve the code construction of the polar code.

A possible use of parity bits and CRC bits at the decoding can be described as following illustrative example decoding procedure (this is merely one illustrative example of decoding procedure).

Example Decoding procedure:

- J3 parity bits are used for tree pruning, and it is performed whenever information bits and associated parity bit are available.
- J2 (or part of J+J2) CRC bits are used for tree pruning, and it is performed whenever information bits and associated CRC bit are available.
- Decoding process can continue as usual if the Parity/CRC bit passes. Decoder uses J+J2 CRC bits at the end to detect errors of the decoded info block.
- If the first parity is failed, and Parity check is not used for termination

    ◦ Penalty on the metric used to rank the paths can be introduced for the paths that fail parity bit.
    ◦ Continue decoding and check subsequent parity bits.
    ◦ If first CRC bit pass
    Continue decoding
    ◦ If first CRC bit fails
    Terminate decoding

- If the first parity is failed, and Parity check is used for termination

    ◦ Decoder can terminate the decoding
    Or
    ◦ If the next parity bit generated with the same set of info bits and extra info bits
    Halt the use of the specific parity bit
    SCL decoding is continued with path metric (discarding first parity check) until the next parity bit
    If the next parity check is failed, decoding can be terminated.
    If the parity is passed, decoder can continue with normal decoding process by discarding first parity check

- When the early termination is scheduled happens with the second or later parity or CRC checks, the same procedure can be used.

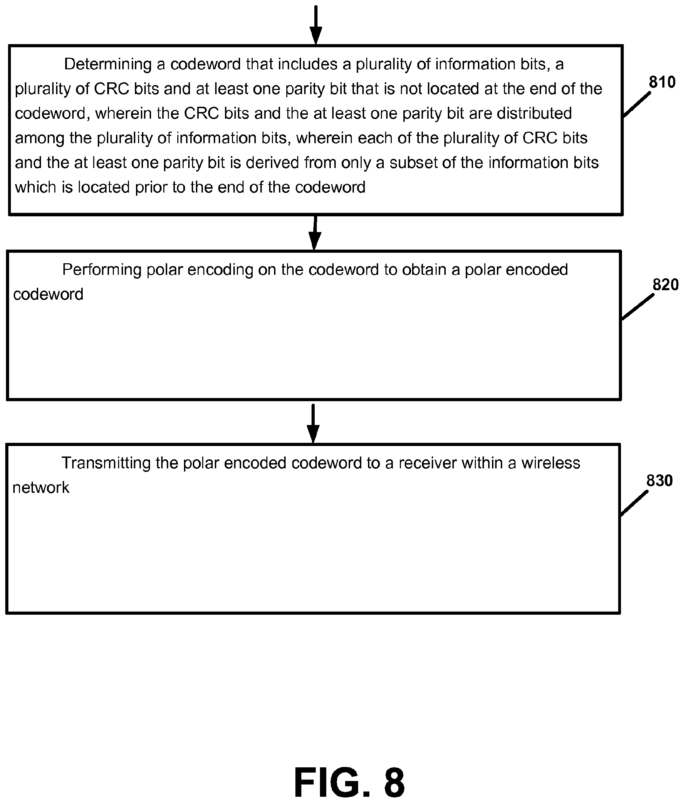

Example 1. FIG. 8 is a flow chart illustrating channel encoding according to an example implementation. Operation 810 includes determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword. Operation 820 includes performing polar encoding on the codeword to obtain a polar encoded codeword. Operation 830 includes transmitting the polar encoded codeword to a receiver within a wireless network.

Example 2. According to an example implementation of the method of example 1: wherein a first subset of the information bits from which a first CRC bit of the plurality of CRC bits or the at least one parity bit is derived is located prior to a second subset of information bits from which a second CRC bit of the plurality of CRC bits or a second parity bit is derived.

Example 3. According to an example implementation of the method of any of examples 1-2: wherein a subset of information bits from which a first CRC bit or the at least one parity bit is derived is located prior to the first CRC bit or the at least one parity bit.

Example 4. According to an example implementation of the method of any of examples 1-3: wherein the subset of information bits comprise: information bits from which a first CRC bit or the at least one parity bit is derived is located, wherein the first CRC bit or the at least one parity bit is located prior to the end of the subset of information bits.

Example 5. According to an example implementation of the method of any of examples 1-4: wherein the determining further comprises: determining the at least one parity bit based on at least two bits of: the plurality of the information bits and the plurality of CRC bits; reordering, within the codeword, one or more bits among the plurality of information bits, the plurality of CRC bits and the at least one parity bit such that the at least one parity bit is allocated to a location before the first CRC bit.

Example 6. According to an example implementation of the method of any of examples 1-5: wherein the at least one parity bit is generated or determined based on one or more information bits used to determine a first CRC bit and the at least one parity bit is allocated to a location before the first CRC bit.

Example 7. According to an example implementation of the method of any of examples 1-6: wherein the at least one parity bit is determined based on a plurality of the information bits.

Example 8. According to an example implementation of the method of any of examples 1-7: wherein the at least one parity bit is determined based on at least one of the CRC bits.

Example 9. According to an example implementation of the method of any of examples 1-8: and further comprising: extending the codeword with a plurality of frozen bits with predetermined values; and mapping at least one CRC bit and at least one parity bit of the codeword to positions of a polar encoder or polar encoding matrix which are more reliable than all positions to which the frozen bits with predetermined values are mapped.

Example 10. According to an example implementation of the method of any of examples 1-9: wherein the polar encoding is performed using a polar encoding matrix, wherein at least one bit of the CRC bits and the parity bit is mapped to a position of the polar encoding matrix that has a lowest row weight among the positions of the polar encoding matrix which are more reliable than all the positions to which the frozen bits with predetermined values are mapped.

Example 11. According to an example implementation of the method of any of examples 1-10: wherein all of the plurality of CRC bits and the at least one parity bit are mapped to positions of the polar encoding matrix that have lowest row weights among the positions of the polar encoding matrix which are more reliable than all the positions to which the frozen bits with predetermined values are mapped.

Example 12. According to an example implementation of the method of any of examples 1-11: and further comprising: extending the codeword with a plurality of frozen bits with predetermined values; and mapping at least one CRC bit and at least one parity bit of the codeword to positions of a polar encoder or polar encoding matrix to which the frozen bits with predetermined values are mapped; and generating at least one CRC bit or at least one parity bit of the codeword based on the frozen bits or a combination of frozen values and a subset of the information bits.

Example 13. According to an example implementation, an apparatus includes at least one processor and at least one memory including computer instructions, when executed by the at least one processor, cause the apparatus to perform a method of any of examples 1-12.

Example 14. According to an example implementation, an apparatus includes means for performing the method of any of examples 1-12.

Example 15. An apparatus including at least one processor and at least one memory including computer instructions, when executed by the at least one processor, cause the apparatus to: determine a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword; perform polar encoding on the codeword to obtain a polar encoded codeword; and transmit the polar encoded codeword to a receiver within a wireless network.

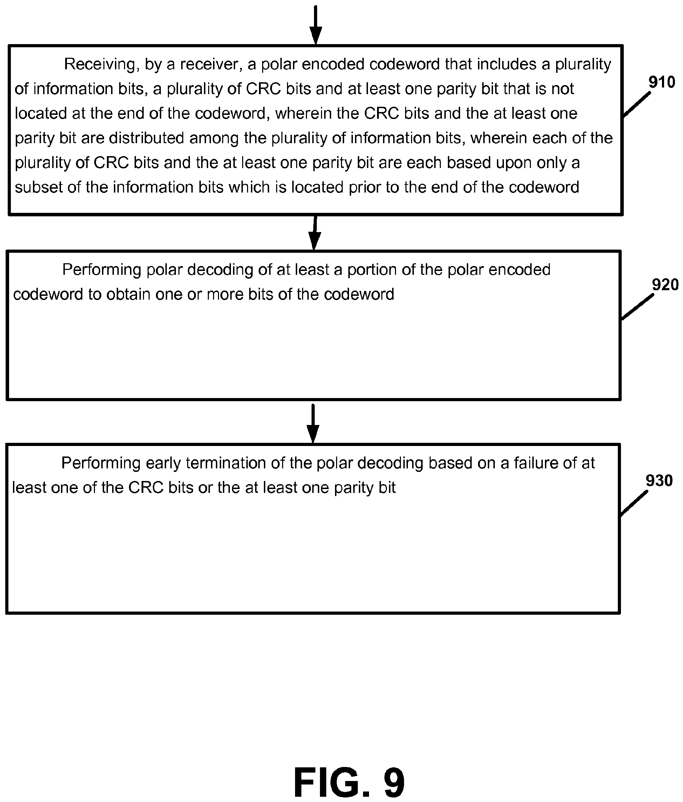

Example 16. According to an example implementation, FIG. 9 is a flow chart illustrating a method of performing channel decoding according to an example implementation. Operation 910 includes receiving, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword. Operation 920 includes performing polar decoding of at least a portion of the polar encoded codeword to obtain one or more bits of the codeword. And, operation 930 includes performing early termination of the polar decoding based on a failure of at least one of the CRC bits or the at least one parity bit.

Example 17. According to an example implementation of the method of example 16: wherein a first subset of the information bits from which a first CRC bit of the plurality of CRC bits or the at least one parity bit is derived is located prior to a second subset of information bits from which a second CRC bit of the plurality of CRC bits or a second parity bit is derived.

Example 18. According to an example implementation of the method of any of examples 16-17: wherein a subset of information bits from which a first CRC bit or the at least one parity bit is derived is located prior to the first CRC bit or the at least one parity bit.

Example 19. According to an example implementation of the method of any of examples 16-18: and further comprising: determining the at least one parity bit based on at least two bits of: the plurality of the information bits and the plurality of CRC bits.

Example 20. According to an example implementation of the method of any of examples 16-19: and further comprising: determining the at least one parity bit based on one or more information bits used to determine a first CRC bit and the at least one parity bit is allocated to a location before the first CRC bit.

Example 21. According to an example implementation of the method of any of examples 16-20: wherein the at least one parity bit is based on a plurality of the information bits.

Example 22. According to an example implementation of the method of any of examples 16-21: wherein the at least one parity bit is based on at least one of the CRC bits.

Example 23. According to an example implementation, an apparatus includes at least one processor and at least one memory including computer instructions, when executed by the at least one processor, cause the apparatus to perform a method of any of claims 16-22.

Example 24. According to an example implementation, an apparatus includes means for performing the method of any of claims 16-22.

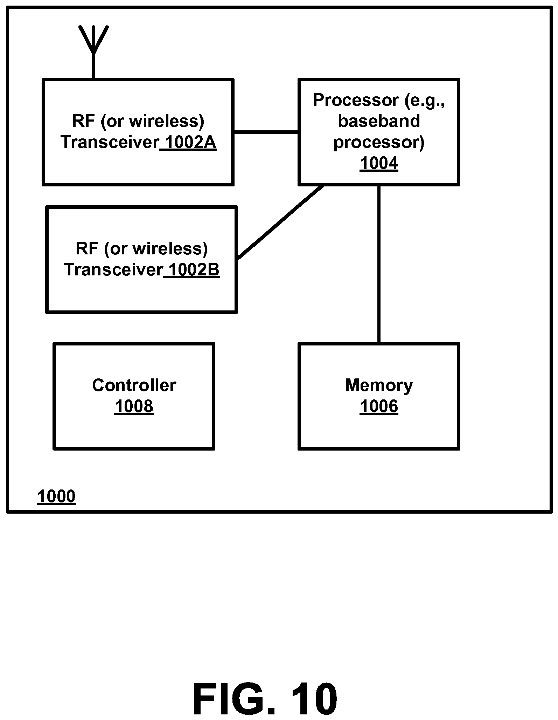

FIG. 10 is a block diagram of a wireless station (e.g., AP, BS, eNB (macro or micro), UE or user device) 1000 according to an example implementation. The wireless station 1000 may include, for example, one or two RF (radio frequency) or wireless transceivers 1002A, 1002B, where each wireless transceiver includes a transmitter to transmit signals and a receiver to receive signals. The wireless station also includes a processor or control unit/entity (controller) 1004 to execute instructions or software and control transmission and receptions of signals, and a memory 1006 to store data and/or instructions.

Processor 1004 may also make decisions or determinations, generate frames, packets or messages for transmission, decode received frames or messages for further processing, and other tasks or functions described herein. Processor 1004, which may be a baseband processor, for example, may generate messages, packets, frames or other signals for transmission via wireless transceiver 1002 (1002A or 1002B). Processor 1004 may control transmission of signals or messages over a wireless network, and may control the reception of signals or messages, etc., via a wireless network (e.g., after being down-converted by wireless transceiver 1002, for example). Processor 1004 may be programmable and capable of executing software or other instructions stored in memory or on other computer media to perform the various tasks and functions described above, such as one or more of the tasks or methods described above. Processor 1004 may be (or may include), for example, hardware, programmable logic, a programmable processor that executes software or firmware, and/or any combination of these. Using other terminology, processor 1004 and transceiver 1002 together may be considered as a wireless transmitter/receiver system, for example.

In addition, referring to FIG. 10, a controller (or processor) 1008 may execute software and instructions, and may provide overall control for the station 1000, and may provide control for other systems not shown in FIG. 10, such as controlling input/output devices (e.g., display, keypad), and/or may execute software for one or more applications that may be provided on wireless station 1000, such as, for example, an email program, audio/video applications, a word processor, a Voice over IP application, or other application or software.

In addition, a storage medium may be provided that includes stored instructions, which when executed by a controller or processor may result in the processor 1004, or other controller or processor, performing one or more of the functions or tasks described above.

According to another example implementation, RF or wireless transceiver(s) 1002A/1002B may receive signals or data and/or transmit or send signals or data. Processor 1004 (and possibly transceivers 1002A/1002B) may control the RF or wireless transceiver 1002A or 1002B to receive, send, broadcast or transmit signals or data.

The embodiments are not, however, restricted to the system that is given as an example, but a person skilled in the art may apply the solution to other communication systems. Another example of a suitable communications system is the 5G concept. It is assumed that network architecture in 5G will be quite similar to that of the LTE-advanced. 5G is likely to use multiple input - multiple output (MIMO) antennas, many more base stations or nodes than the LTE (a so-called small cell concept), including macro sites operating in co-operation with smaller stations and perhaps also employing a variety of radio technologies for better coverage and enhanced data rates.

It should be appreciated that future networks will most probably utilize network functions virtualization (NFV) which is a network architecture concept that proposes virtualizing network node functions into "building blocks" or entities that may be operationally connected or linked together to provide services. A virtualized network function (VNF) may comprise one or more virtual machines running computer program codes using standard or general type servers instead of customized hardware. Cloud computing or data storage may also be utilized. In radio communications this may mean node operations may be carried out, at least partly, in a server, host or node operationally coupled to a remote radio head. It is also possible that node operations will be distributed among a plurality of servers, nodes or hosts. It should also be understood that the distribution of labor between core network operations and base station operations may differ from that of the LTE or even be non-existent.

Implementations of the various techniques described herein may be implemented in digital electronic circuitry, or in computer hardware, firmware, software, or in combinations of them. Implementations may be implemented as a computer program product, i.e., a computer program tangibly embodied in an information carrier, e.g., in a machine-readable storage device or in a propagated signal, for execution by, or to control the operation of, a data processing apparatus, e.g., a programmable processor, a computer, or multiple computers. Implementations may also be provided on a computer readable medium or computer readable storage medium, which may be a non-transitory medium. Implementations of the various techniques may also include implementations provided via transitory signals or media, and/or programs and/or software implementations that are downloadable via the Internet or other network(s), either wired networks and/or wireless networks. In addition, implementations may be provided via machine type communications (MTC), and also via an Internet of Things (IOT).

The computer program may be in source code form, object code form, or in some intermediate form, and it may be stored in some sort of carrier, distribution medium, or computer readable medium, which may be any entity or device capable of carrying the program. Such carriers include a record medium, computer memory, read-only memory, photoelectrical and/or electrical carrier signal, telecommunications signal, and software distribution package, for example. Depending on the processing power needed, the computer program may be executed in a single electronic digital computer or it may be distributed amongst a number of computers.

Furthermore, implementations of the various techniques described herein may use a cyber-physical system (CPS) (a system of collaborating computational elements controlling physical entities). CPS may enable the implementation and exploitation of massive amounts of interconnected ICT devices (sensors, actuators, processors microcontrollers,...) embedded in physical objects at different locations. Mobile cyber physical systems, in which the physical system in question has inherent mobility, are a subcategory of cyber-physical systems. Examples of mobile physical systems include mobile robotics and electronics transported by humans or animals. The rise in popularity of smartphones has increased interest in the area of mobile cyber-physical systems. Therefore, various implementations of techniques described herein may be provided via one or more of these technologies.

A computer program, such as the computer program(s) described above, can be written in any form of programming language, including compiled or interpreted languages, and can be deployed in any form, including as a stand-alone program or as a module, component, subroutine, or other unit or part of it suitable for use in a computing environment. A computer program can be deployed to be executed on one computer or on multiple computers at one site or distributed across multiple sites and interconnected by a communication network.

Method steps may be performed by one or more programmable processors executing a computer program or computer program portions to perform functions by operating on input data and generating output. Method steps also may be performed by, and an apparatus may be implemented as, special purpose logic circuitry, e.g., an FPGA (field programmable gate array) or an ASIC (application-specific integrated circuit).

Processors suitable for the execution of a computer program include, by way of example, both general and special purpose microprocessors, and any one or more processors of any kind of digital computer, chip or chipset. Generally, a processor will receive instructions and data from a read-only memory or a random access memory or both. Elements of a computer may include at least one processor for executing instructions and one or more memory devices for storing instructions and data. Generally, a computer also may include, or be operatively coupled to receive data from or transfer data to, or both, one or more mass storage devices for storing data, e.g., magnetic, magneto-optical disks, or optical disks. Information carriers suitable for embodying computer program instructions and data include all forms of non-volatile memory, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory may be supplemented by, or incorporated in, special purpose logic circuitry.

To provide for interaction with a user, implementations may be implemented on a computer having a display device, e.g., a cathode ray tube (CRT) or liquid crystal display (LCD) monitor, for displaying information to the user and a user interface, such as a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input.

Implementations may be implemented in a computing system that includes a back-end component, e.g., as a data server, or that includes a middleware component, e.g., an application server, or that includes a front-end component, e.g., a client computer having a graphical user interface or a Web browser through which a user can interact with an implementation, or any combination of such back-end, middleware, or front-end components. Components may be interconnected by any form or medium of digital data communication, e.g., a communication network. Examples of communication networks include a local area network (LAN) and a wide area network (WAN), e.g., the Internet.

While certain features of the described implementations have been illustrated as described herein, many modifications, substitutions, changes and equivalents will now occur to those skilled in the art. It is, therefore, to be understood that the appended claims are intended to cover all such modifications and changes as fall within the true spirit of the various embodiments.


**Claims**

1. A method of performing channel encoding comprising:

   determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword;
   performing polar encoding on the codeword to obtain a polar encoded codeword; and
   transmitting the polar encoded codeword to a receiver within a wireless network.

2. The method of claim 1:

   wherein a first subset of the information bits from which a first CRC bit of the plurality of CRC bits or the at least one parity bit is derived is located prior to a second subset of information bits from which a second CRC bit of the plurality of CRC bits or a second parity bit is derived.

3. The method of claim 1:

   wherein a subset of information bits from which a first CRC bit or the at least one parity bit is derived is located prior to the first CRC bit or the at least one parity bit.

4. The method of claim 3 wherein the subset of information bits comprises:

   information bits from which a first CRC bit or the at least one parity bit is derived, wherein the first CRC bit or the at least one parity bit is located prior to the end of the subset of information bits.

5. The method of any of claims 1-4 wherein the determining further comprises:

   determining the at least one parity bit based on at least two bits of: the plurality of the information bits and the plurality of CRC bits;
   reordering, within the codeword, one or more bits among the plurality of information bits, the plurality of CRC bits and the at least one parity bit such that the at least one parity bit is allocated to a location before the first CRC bit.

6. The method of any of claims 1-5 wherein the at least one parity bit is generated or determined based on one or more information bits used to determine a first CRC bit and the at least one parity bit is allocated to a location before the first CRC bit.

7. The method of any of claims 1-6 wherein the at least one parity bit is determined based on a plurality of the information bits.

8. The method of claim 1 wherein the at least one parity bit is determined based on at least one of the CRC bits.

9. The method of any of claims 1-8 and further comprising:

   extending the codeword with a plurality of frozen bits with predetermined values; and
   mapping at least one CRC bit and at least one parity bit of the codeword to positions of a polar encoder or polar encoding matrix which are more reliable than all positions to which the frozen bits with predetermined values are mapped.

10. The method of claim 9 wherein the polar encoding is performed using a polar encoding matrix, wherein at least one bit of the CRC bits and the parity bit is mapped to a position of the polar encoding matrix that has a lowest row weight among the positions of the polar encoding matrix which are more reliable than all the positions to which the frozen bits with predetermined values are mapped.

11. The method of claim 10 wherein all of the plurality of CRC bits and the at least one parity bit are mapped to positions of the polar encoding matrix that have lowest row weights among the positions of the polar encoding matrix which are more reliable than all the positions to which the frozen bits with predetermined values are mapped.

12. The method of any of claims 1-8 and further comprising:

extending the codeword with a plurality of frozen bits with predetermined values; and
mapping at least one CRC bit and at least one parity bit of the codeword to positions of a polar encoder or polar encoding matrix to which the frozen bits with predetermined values are mapped;
generating at least one CRC bit or at least one parity bit of the codeword based on the frozen bits or a combination of frozen values and a subset of the information bits.

13. An apparatus comprising at least one processor and at least one memory including computer instructions, when executed by the at least one processor, cause the apparatus to perform a method of any of claims 1-12.

14. An apparatus comprising means for performing the method of any of claims 1-12.

15. An apparatus comprising at least one processor and at least one memory including computer instructions, when executed by the at least one processor, cause the apparatus to:

determine a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword;
perform polar encoding on the codeword to obtain a polar encoded codeword; and
transmit the polar encoded codeword to a receiver within a wireless network.

16. A method of performing channel decoding comprising:

receiving, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword;
performing polar decoding of at least a portion of the polar encoded codeword to obtain one or more bits of the codeword; and
performing early termination of the polar decoding based on a failure of at least one of the CRC bits or the at least one parity bit.

17. The method of claim 16:

wherein a first subset of the information bits from which a first CRC bit of the plurality of CRC bits or the at least one parity bit is derived is located prior to a second subset of information bits from which a second CRC bit of the plurality of CRC bits or a second parity bit is derived.

18. The method of claim 16:

wherein a subset of information bits from which a first CRC bit or the at least one parity bit is derived is located prior to the first CRC bit or the at least one parity bit.

19. The method of any of claims 16-18 further comprising:

determining the at least one parity bit based on at least two bits of: the plurality of the information bits and the plurality of CRC bits.

20. The method of any of claims 16-18 further comprising:

determining the at least one parity bit based on one or more information bits used to determine a first CRC bit and the at least one parity bit is allocated to a location before the first CRC bit.

21. The method of any of claims 16-20 wherein the at least one parity bit is based on a plurality of the information bits.

22. The method of any of claims 16-20 wherein the at least one parity bit is based on at least one of the CRC bits.

23. An apparatus comprising at least one processor and at least one memory including computer instructions, when executed by the at least one processor, cause the apparatus to perform a method of any of claims 16-22.

24. An apparatus comprising means for performing the method of any of claims 16-22.

**FIG. 1**

FIG. 2

FIG. 3

410

412

414

| Information payload: K bits | → | Distributed CRC: J + J2 bits | → | Distributed parity bits: J3 |

**FIG. 4**

FIG. 5

512

$b_1, b_2, b_3, \ldots, b_K$

J + J2 : CRC distribution

$e_1, e_2, e_3, \ldots, e_{K+J+J2}$

$e_1, e_2, e_3, \ldots, e_m$

514

J3 : Parity generation

$p_1, p_2, \ldots, p_{J3}$

Reordering

516

$f_1, f_2, \ldots, f_{K+J+J2+J3}$

$e_1, e_2, e_3, e_4, e_5, e_6, e_7, e_8, e_9, e_{10}, e_{11}, e_{12}, e_{13}, e_{14}.............................., e_m$

$CRC_1$ $CRC_2$

$p_1$ $p_2$ $p_3$

**FIG. 6**

G =

**FIG. 7**

Determining a codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit is derived from only a subset of the information bits which is located prior to the end of the codeword

810

Performing polar encoding on the codeword to obtain a polar encoded codeword

820

Transmitting the polar encoded codeword to a receiver within a wireless network

830

# FIG. 8

Receiving, by a receiver, a polar encoded codeword that includes a plurality of information bits, a plurality of CRC bits and at least one parity bit that is not located at the end of the codeword, wherein the CRC bits and the at least one parity bit are distributed among the plurality of information bits, wherein each of the plurality of CRC bits and the at least one parity bit are each based upon only a subset of the information bits which is located prior to the end of the codeword

910

Performing polar decoding of at least a portion of the polar encoded codeword to obtain one or more bits of the codeword

920

Performing early termination of the polar decoding based on a failure of at least one of the CRC bits or the at least one parity bit

930

# FIG. 9

FIG. 10

Europäisches
Patentamt

European
Patent Office

Office européen
des brevets

## EUROPEAN SEARCH REPORT

Application Number

EP 17 30 5472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YU QINGPING ET AL: "Hybrid Parity-Check and CRC Aided SCL Decoding for Polar Codes", 2016 IEEE INTERNATIONAL CONFERENCE ON INTERNET OF THINGS (ITHINGS) AND IEEE GREEN COMPUTING AND COMMUNICATIONS (GREENCOM) AND IEEE CYBER, PHYSICAL AND SOCIAL COMPUTING (CPSCOM) AND IEEE SMART DATA (SMARTDATA), IEEE, 15 December 2016 (2016-12-15), pages 711-716, XP033093024, DOI: 10.1109/ITHINGS-GREENCOM-CPSCOM-SMARTDATA.2016.152 [retrieved on 2017-05-01] * Section III; figures 3, 4 * | 1-24 | INV. H03M13/13 H03M13/09 |
| A | ERICSSON: "Design of CRC-assisted Polar Code", 3GPP DRAFT; R1-1701630 DESIGN OF CRC-ASSISTED POLAR CODE, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Athens, Greece; 20170213 - 20170217 12 February 2017 (2017-02-12), XP051208797, Retrieved from the Internet: URL:http://www.3gpp.org/ftp/Meetings_3GPP_SYNC/RAN1/Docs/ [retrieved on 2017-02-12] * the whole document * | 1-24 | TECHNICAL FIELDS SEARCHED (IPC) H03M |

-/--

The present search report has been drawn up for all claims

| Place of search | Date of completion of the search | Examiner |
|---|---|---|
| Munich | 12 October 2017 | Farman, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches
Patentamt

European
Patent Office

Office européen
des brevets

**EUROPEAN SEARCH REPORT**

Application Number

EP 17 30 5472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NOKIA ET AL: "Polar codes design for UL control", 3GPP DRAFT; R1-1701033 POLAR CODE DESIGN FOR UL CONTROL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Spokane, US; 20170116 - 20170120 9 January 2017 (2017-01-09), XP051202347, Retrieved from the Internet: URL:http://www.3gpp.org/ftp/tsg_ran/WG1_RL 1/TSGR1_AH/NR_AH_1701/Docs/ [retrieved on 2017-01-09] * the whole document * | 1-24 | |
| A | ZHOU HUAYI ET AL: "Segmented CRC-Aided SC List Polar Decoding", 2016 IEEE 83RD VEHICULAR TECHNOLOGY CONFERENCE (VTC SPRING), IEEE, 15 May 2016 (2016-05-15), pages 1-5, XP032918751, DOI: 10.1109/VTCSPRING.2016.7504469 [retrieved on 2016-07-05] * section III.B; figures 6,7 * * section IV.A * | 1-24 | TECHNICAL FIELDS SEARCHED (IPC) |

-/--

The present search report has been drawn up for all claims

| Place of search | Date of completion of the search | Examiner |
|---|---|---|
| Munich | 12 October 2017 | Farman, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

EPO FORM 1503 03.82 (P04C01)

page 2 of 3

Europäisches
Patentamt

European
Patent Office

Office européen
des brevets

# EUROPEAN SEARCH REPORT

Application Number

EP 17 30 5472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WANG TAO ET AL: "Parity-Check-Concatenated Polar Codes", IEEE COMMUNICATIONS LETTERS, IEEE SERVICE CENTER, PISCATAWAY, NJ, US, vol. 20, no. 12, December 2016 (2016-12), pages 2342-2345, XP011636292, ISSN: 1089-7798, DOI: 10.1109/LCOMM.2016.2607169 [retrieved on 2016-12-08] * section II.A; figures 1,2 * | 1-24 | |
| A | CN 105 680 883 A (UNIV HUAZHONG SCIENCE TECH) 15 June 2016 (2016-06-15) * figure 3 * | 1-24 | |
| A | CN 106 209 113 A (UNIV CHINA PETROLEUM) 7 December 2016 (2016-12-07) * figure 1 * | 1-24 | |
| A | ZTE ET AL: "Performance evaluation of PC Polar Codes and CA Polar codes for eMBB", 3GPP DRAFT; R1-1704383 PERFORMANCE EVALUATION OF PC POLAR CODES AND CA POLAR CODES FOR EMBB_FINAL, 3RD GENERATION PARTNERSHIP PROJECT (3GPP), MOBILE COMPETENCE CENTRE ; 650, ROUTE DES LUCIOLES ; F-069 , vol. RAN WG1, no. Spokane, USA; 20170403 - 20170407 25 March 2017 (2017-03-25), XP051251185, Retrieved from the Internet: URL:http://www.3gpp.org/ftp/tsg_ran/WG1_RL 1/TSGR1_88b/Docs/ [retrieved on 2017-03-25] * the whole document * | 1-24 | TECHNICAL FIELDS SEARCHED (IPC) |

The present search report has been drawn up for all claims

| Place of search | Date of completion of the search | Examiner |
|---|---|---|
| Munich | 12 October 2017 | Farman, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 30 5472

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2017

| Patent document cited in search report | | Publication date | Patent family member(s) | Publication date |
|---|---|---|---|---|
| CN 105680883 | A | 15-06-2016 | NONE | |
| CN 106209113 | A | 07-12-2016 | NONE | |

For more details about this annex : see Official Journal of the European Patent Office, No. 12/82

EPO FORM P0459